# EUROPÄISCHE PATENTANMELDUNG

(11) **EP 1 293 793 A1**
(43) Veröffentlichungstag der Anmeldung: **19.03.2003**
(21) Anmeldenummer: 01122284.1
(22) Anmeldetag: 18.09.2001
(51) Int. Cl.: G01R 33/28

(54) **Bildgebungskatheter für die bildgebende magnetische Resonanz**

(71) Anmelder: JOMED NV, 6235 NS Ulestraten (NL)
(72) Erfinder: Matschl, Volker, 96050 Bamberg (DE); Jänsch, Heinz-Julius, 35037 Marburg (DE); Klose, Klaus Jochen, 35112 Fronhausen (DE)
(74) Vertreter: Schmitz, Hans-Werner, Dipl.-Ing.

(57) **Zusammenfassung**

Um die Ausleuchtung von Gefässen zur Bestimmung der Morphologie von Plaque-Ablagerungen zu verbessern, schafft die Erfindung einen Bildgebungskatheter (1) mit einem langgestreckten Trägerteil (2), auf dem zwei elektromagnetische Detektionsspulenwindungen (3, 4) angeordnet sind. Die Leiter (5 bis 8) dieser Spule (3, 4) sind in Längsrichtung (L) des Trägerteils (2) positioniert und gleichgerichtet bestromt. Um das Trägerteil (2) ist ein Distanzhalter (9) herum angeordnet, was zu einer nahezu konzentrischen Feldverteilung und damit einer konzentrischen Ausleuchtung des zu untersuchenden umgebenden Gewebes führt.

## Beschreibung

Die Erfindung betrifft einen Bildgebungskatheter gemäss Anspruch 1.

Cardiovaskuläre Erkrankungen stellen in den westlichen Industrienationen die häufigste Todesursache dar. Die Hauptmanifestation dieser Erkrankung, die Arteriosklerose, äussert sich in den unterschiedlichen Gefässsystemen des menschlichen Organismus mit Stenosen oder Verschlüssen nutritiver Gefässe. Symptomatische Gefässverschlüsse werden zunehmend mit perkutanen Verfahren behandelt. Als perkutane transluminale Angioplastie (PTA) wird im engeren Sinne die Ballondilatation von arteriosklerotisch verengten oder verschlossenen Gefässen bezeichnet.

Obwohl diese Behandlungsart hohe Erfolgsraten zeigt, ergibt sich das Problem der Restenosierung nach primär erfolgreicher PTA. Der Grund für die Restenosierung, die zu einer erneuten Verengung oder zu einem erneuten Verschluss führen kann, liegt nach dem Ergebnis aktueller Forschung entweder an thrombotischen Frühverschlüssen innerhalb von Tagen beziehungsweise Wochen nach der PTA, an Restenosierungen innerhalb des ersten bis sechsten Monats sowie dem Prozess der Grunderkrankung der Arteriosklerose innerhalb etwa einem Jahr.

Bei der Beurteilung von Prognose und Verlauf der Arteriosklerose wird der histopathologischen Zusammensetzung des arteriosklerotischen Plaques zunehmende Bedeutung beigemessen. Eine solche Analyse der Plaque-Morphologie ist mit herkömmlichen, zur Abklärung der arteriosklerotischen Gefässkrankheiten eingesetzten Verfahren, nur bedingt beziehungsweise gar nicht möglich. So entspricht die konventionelle Angiographie lediglich einer Luminographie der blutdurchströmten Gefässteile, die die Beschaffenheit der Gefässwand vollkommen unbeleuchtet lässt. Um die Plaque-Struktur zu analysieren, wurden deshalb Verfahren wie die Angioskopie und der intravaskuläre Ultraschall untersucht. Auch hier waren die Resultate nicht vielversprechend. Mit der Angioskopie gelingt die Darstellung lediglich der Gefässoberfläche, und der als Goldstandard deklarierte intravaskuläre Ultraschall gelangt durch kalkinduzierte Auslöschphänomene schnell an seine Grenzen.

Mit der Computertomographie (CT) und der Magnetresonanz-Angiographie (MRA) haben sich nichtinvasive Schnittbildverfahren etabliert, die nicht nur eine Beurteilung des Gefässlumens, sondern auch der Gefässwände ermöglichen. Erlaubt die CT eine Quantifizierung der verkalkten Gefässwandanteile, so ermöglicht der hohe Weichteilkontrast eine weitergehende Plaque-Charakterisierung mit dem MR-Experiment. Eine ausreichend räumliche Auflösung war bislang allerdings nur unter langen Untersuchungszeiten in peripheren Gefässen möglich.

Mit der Anwendung intravaskulärer Empfangsspulen kann das Signal-zu-Rausch-Verhältnis und damit die räumliche Auflösung durch die unmittelbare Nähe zur Gefässwand verbessert werden. Hierzu wurden im Stand der Technik Zylinderspulen entwickelt, die zwar eine gute axiale Auflösung im in-vitro-Experiment ergaben, die sich jedoch auf Grund ihrer hohen Empfindlichkeit gegenüber pulsatiler Blutflussschwankungen für eine in-vivo-Anwendung für ungeeignet erwiesen.

Aus der Veröffentlichung in der Zeitschrift Radiology 204769-774, 1997, ("Intravascular MR Imaging of arterioslerotic plaque: "Ex-Vivo" analysis of human femoral arteries with histological correlation") ist die Verwendung einer einzelnen Leiterschleife (Single-Loop) in einem kommerziellen PTA-Ballonkatheter bekannt. Obwohl dieses Untersuchungskonzept gewisse Vorteile hinsichtlich geringem Durchmessers, hoher Flexibilität eines langen Bildgebungsbereiches, einer zuverlässigen Unterdrückung störender, durch den Blutfluss verursachter Bewegungsartefakte und einer Steigerung des Signal-Rausch-Verhältnisses ermöglicht, gibt es bisher allerdings noch keine Untersuchungsvorrichtung, welche eine völlig konzentrische Ausleuchtung des MRT-Bildes um die Spule herum ermöglicht. Die bisher bekannten Spulen, wie zum Beispiel Endorektal-Spulen, bestehen aus einer einfachen Leiterschleife, die auf der Innenseite eines inflatierbaren Ballons montiert ist. Die Folge ist, dass bei der Applikation einer derartigen Konstruktion das umliegende Gewebe nicht gleichmässig ausgeleuchtet wird. Die hohe Signalintensität direkt an den Spulenleitern führt bei der Bildrekonstruktion zu einer lokalen Übersteuerung des MR-Signals, welches demzufolge nicht korrekt dekodiert werden kann. Andererseits erhält man von den in der Schnittebene, orthogonal zu den Spulenleitern befindlichen Regionen nur ein relativ schwaches Signal. Daraus resultiert dann eine partiell unvollständige Ausleuchtung der zu untersuchenden interessantesten Bereiche, was eine zweite, um 90° verdrehte Positionierung des Katheters zur Darstellung der gesamten Lumenwand erforderlich machen kann. Grund dieser Mängel ist die nicht-konzentrische Magnetfeldverteilung um die Empfangsspule herum.

Es ist daher Aufgabe der vorliegenden Erfindung, einen Bildgebungskatheter zu schaffen, der eine möglichst konzentrische Ausleuchtung des umliegenden, zu untersuchenden Gewebes und damit eine Minimierung der Untersuchungszeit möglich macht.

Die Lösung dieser Aufgabe erfolgt durch die Merkmale des Anspruches 1.

Mit dem erfindungsgemässen Bildgebungskatheter, der insbesondere intravaskulär einsetzbar ist, ist es zunächst möglich, eine konzentrische Ausleuchtung des umgebenden Gewebes, wie insbesondere des Gewebes innerhalb einer Gefässstenose, zu erreichen, da die Leiter, die auf dem Trägerteil montiert sind, durch den Distanzhalter während der Untersuchung nicht an der Gefässwand anliegen, da dort der Distanzhalter plaziert werden kann. Somit wirken sich in gewissem Rahmen unvermeidliche Inhomogenitäten der Magnetfeldverteilung auf Grund der diskreten Leiteranordnung der Detektionsspule an der Gefäßwand nicht aus, da sich die Feldinhomogenitäten innerhalb des Distanzhalters befinden und sich somit nicht mehr negativ auf die Bildgebung auswirken. Insbesondere ergibt sich mit dem erfindungsgemässen Bildgebungskatheter eine relativ konzentrische Feldverteilung, die selbst das Fernfeld des untersuchten Gebietes noch verhältnismässig stark ausleuchtet. Hiermit ist es möglich, eine weitgehend konzentrische Ausleuchtung der Gefässwand in Kombination mit einer möglichst hohen Signaleindringtiefe zu erreichen.

Ferner haben im Rahmen der Erfindung durchgeführte Untersuchungen ergeben, dass Erwärmungseffekte minimierbar sind, da die Leiter der Spulen durch den Distanzhalter nicht an der Gefässwand anliegen können.

Desweiteren ist es mit dem erfindungsgemässen Bildgebungskatheter möglich, die morphologische Charakterisierung einzelner Gefässwandbestandteile beziehungsweise verschiedener Bestandteile des arteriosklerotischen Plaque-Materiales durchzuführen. Somit ist es mit dem erfindungsgemässen Bildgebungskatheter möglich, derzeit etablierte sowie preliminäre Therapiekonzepte im Rahmen der peripheren arteriellen Verschlusskrankheiten zu validieren beziehungsweise zu optimieren. Insbesondere ergeben sich im Hinblick auf die vermeintlichen Mechanismen der Plättchenaggregation, Intimaproliferation und Anlagerung thrombotischen Materials, mit dem erfindungsgemässen Bildgebungskatheter interessante Verfahrungsmöglichkeiten, mit der die Gefässwand direkt nach der Intervention beurteilt werden kann, sodass die Interventionsprognose optimierbar ist.

Die Unteransprüche haben vorteilhafte Weiterbildungen der Erfindung zum Inhalt.

Vorzugsweise ist das Trägerteil als aufweitbarer Ballon ausgebildet, der zur Minimierung von Kosten und zur Erleichterung der Herstellbarkeit ein Teil eines handelsüblichen PTA-Katheters sein kann. Alternativ könnte das Trägerteil auch als aufweitbarer Käfig ausgebildet sein.

Die Detektionsspulen sind insbesondere als Magnetresonanz-Spulen (MR-Spulen) ausgebildet. Die Leiter der Spulen können vorzugsweise aus Kupfer bestehen, wobei ein möglichst grosser Durchmesser angestrebt wird. Besonders bevorzugte Durchmesserbereiche liegen zwischen 0,1 bis 0,3 mm, wobei ein besonders bevorzugter Durchmesser 0,18 mm beträgt.

Die Leiter der Spulen können beispielsweise mittels eines Klebers auf der Aussenfläche des vorzugsweise als Ballon ausgebildeten Trägerteils fixiert werden.

Vorzugsweise weist das von der Detektionsspule erzeugte Magnetfeld Dipolcharakter auf, was bedeutet, dass das Magnetfeld mit 1/ρ² abfällt, wobei ρ der Durchmesser des vorzugsweise als Ballon ausgebildeten Trägerteiles ist. Hieraus folgt, dass im Fernfeld dieser speziellen Spulenanordnung eine völlig konzentrische Magnetfeldverteilung herrscht und somit eine konzentrische Ausleuchtung und auf Grund des Dipolcharakters eine hohe Eindringtiefe möglich ist.

Der Distanzhalter ist vorzugsweise als inflatierbarer Aussenballon ausgebildet.

Bei einer besonders bevorzugten Ausführungsform ist der Aussenballon konzentrisch um das als Ballon ausgebildete Trägerteil herum angeordnet.

Schliesslich weist der erfindungsgemässe Bildgebungskatheter bei einer besonders bevorzugten Ausführungsform ein spezielles Anschlussstück auf, das separate Zuleitungen für die Inflatierung der Ballons, ein Lumen für den Führungsdraht des Katheters sowie ein elektrisches Anschlusskabel für die Spulen aufweist, das vorzugsweise als Koaxkabel ausgebildet ist.

Weitere Einzelheiten, Merkmale und Vorteile der Erfindung ergeben sich aus nachfolgender Beschreibung von Ausführungsbeispielen anhand der Zeichnung.

Es zeigt:
- Fig. 1: eine schematisch stark vereinfachte Darstellung einer Gesamtansicht eines erfindungsgemässen Bildgebungskatheters,
- Fig. 2: eine der Fig. 1 entsprechende vergrösserte Darstellung des Bereiches eines Trägerteiles und eines Distanzhalters des Bildgebungskatheters gemäss Fig. 1,
- Fig. 3: eine schematisch stark vereinfachte Darstellung der Spulenarchitektur des erfindungsgemässen Bildgebungskatheters,
- Fig. 4: ein Contour-Plot der Niveaulinien des Magnetfeldbetrages einer Double-Loop-Spulenanordnung,
- Fig. 5: ein Diagramm der Darstellung der Schwankungen des Magnetfeldbetrages einer Double-Loop-Anordnung, und
- Fig. 6: ein Diagramm zur Darstellung der Schwankungen des Magnetfeldbetrages einer Dreifachspulen-Anordnung (Triple-Loop-Spulenanordnung).

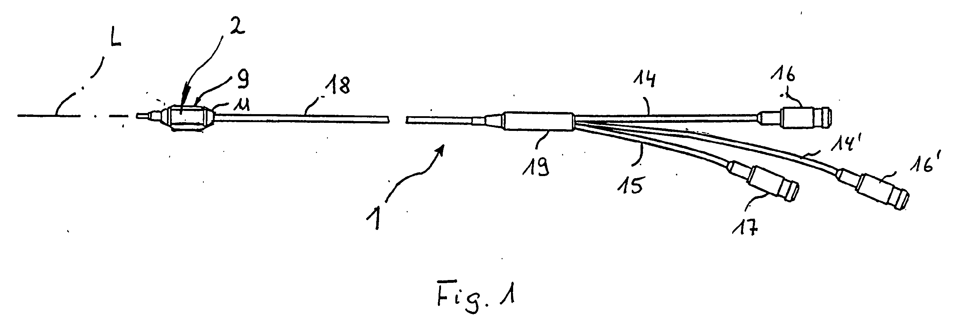

In Fig. 1 ist eine schematisch vereinfachte Darstellung eines erfindungsgemässen Bildgebungskatheters 1 dargestellt. Der Bildgebungskatheter 1 basiert auf einem herkömmlichen PTA-Katheter, der ausgehend von drei Luer-Anschlussstücken 16, 16' und 17 über zugeordnete Leitungsabschnitte 14, 14' und 15 in ein Y-Verbindungsstück 19 übergeht. Hierbei dient das Anschlussstück 16 beispielsweise für den üblichen Führungsdraht und die Anschlussstücke 16' und 17 für die Inflatierung eines später zu beschreibenden Außen- und Innenballons. Von dem Verbindungsstück 19 aus führt ein Katheterschaft 18 über ein Anschlussstück 11 zu einem Trägerteil 2, das im Beispielsfalle in bevorzugter Weise als handelsüblicher PTA-Ballon ausgebildet ist, der durch Einleiten eines Fluids über eine spezielle Zuleitung aufgeweitet werden kann.

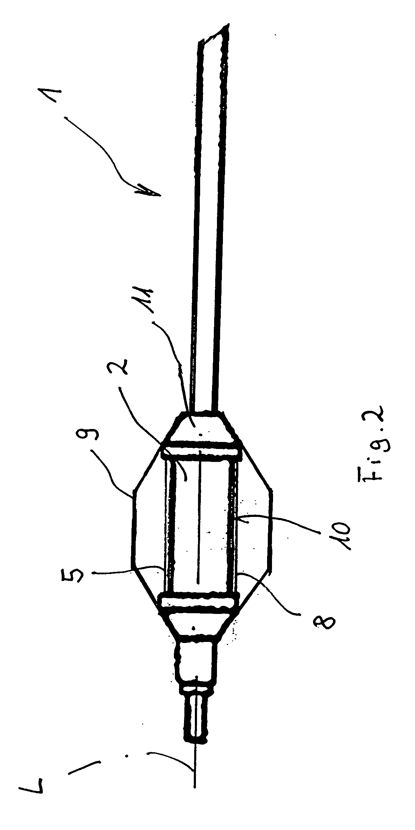

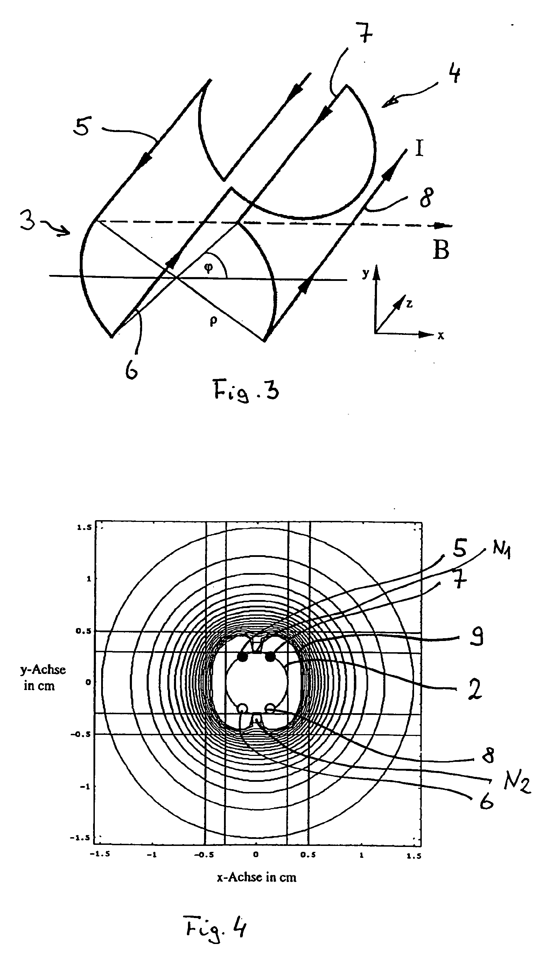

Das als Ballon ausgebildete Trägerteil 2 trägt die eigentliche Detektionsspule, die nachfolgend anhand eines Spezialfalles in Fig. 2 und 3 näher beschrieben wird.

Um das als Ballon ausgebildete Trägerteil 2 ist ein Distanzhalter 9 herum angeordnet. Der Distanzhalter 9 ist im Beispielsfalle als Aussen-Ballon ausgebildet, der über eine separate Leitung ebenfalls inflatierbar und damit aufweitbar ist.

Wie sich aus der Darstellung der Fig. 1 ergibt, sind das Trägerteil 2 und der Distanzhalter 9 konzentrisch aneinander und um die Längsachse L des Katheterschafts 18 herum angeordnet.

Aus Fig. 2 ergibt sich in schematich stark vereinfachter Art und Weise der Aufbau des Ballon-Bereiches mit der Spulenarchitektur des erfindungsgemässen Bildgebungskatheters 1.

Auf dem Träger 2 sind im Beispielsfalle der Double-Loop zwei aus der schematischen Darstellung aus Fig. 3 ersichtliche Spulenwindungen 3 und 4 angeordnet. Die Leiter 5, 6, 7 und 8, von denen in Fig. 2 die Leiter 5 und 8 sichtbar sind, sind entlang der Längserstreckung des Trägerteiles 2, das in Fig. 3 nicht sichtbar ist und dessen Längsachse L in Fig. 3 der z-Achse entspricht, angeordnet.

Um das Trägerteil 2 und damit um die Spulenwindungen 3, 4, die einen Double-Loop bildet, ist der Abstandshalter 9 herum angeordnet. Da es sich bei der besonders bevorzugten Ausführungsform um einen Aussen-Ballon handelt, ist dieser konzentrisch um den Innen-Ballon 2 herum angeordnet.

Wie sich aus Fig. 3 ergibt, sind die Leiter 5 und 7 in der einen Richtung und die Leiter 6 und 8 in der anderen Richtung jeweils gleichgerichtet bestromt. Der Betrag des Stromes I ist in allen Fällen der selbe.

In Fig. 3 entspricht das Mass ρ dem Durchmesser des Katheters und der Winkel ϕ bestimmt die genaue Position der einzelnen Stützstellen der Leiter 5 bis 8 auf der Aussenfläche 10 des Ballons 2.

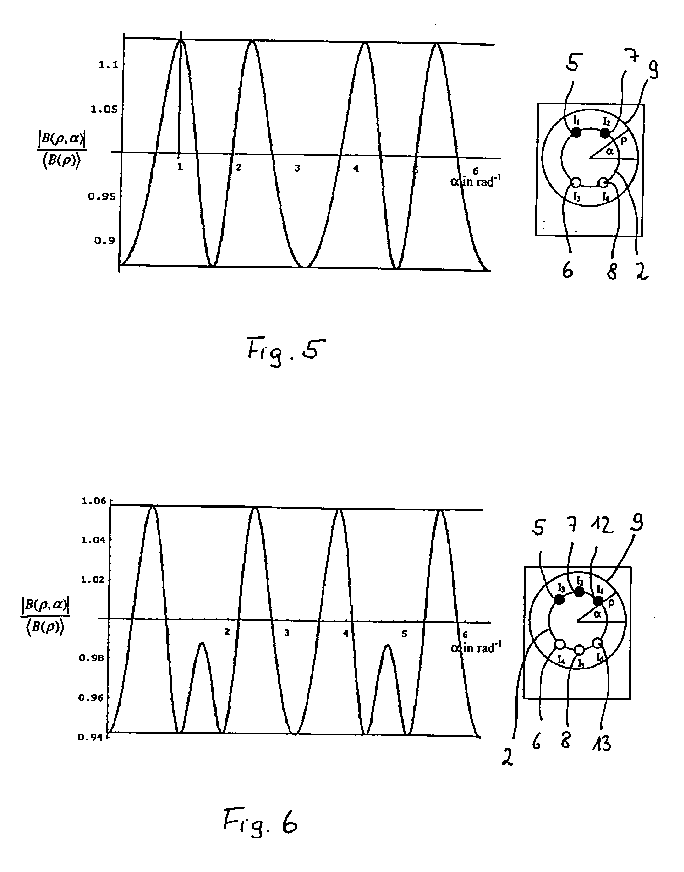

Ferner ist in Fig. 3 die Richtung des Stromes I und die Richtung des Magnetfeldes B, das längs der X-Achse von dieser Spulenanordnung erzeugt wird, eingezeichnet. In Fig. 4 ist ein sogenanntes Contour-Plot der Niveaulinien des Magnetfeldbetrages der Double-Loop-Anordnung gemäss Fig. 3 dargestellt.

Wie sich aus der Darstellung ergibt, sind die Leiter 5 und 7 in der gleichen Richtung bestromt und die Leiter 6 und 8 ebenfalls gleichgerichtet, jedoch zu den Leitern 5 und 7 in der entgegengesetzten Richtung bestromt. Somit sind die benachbarten Leiter 5 und 7, die auf der Aussenfläche des Ballons 2 angeordnet sind und deren benachbarten Leiter 6 und 8 jeweils gleichgerichtet bestromt.

Auf Grund dieser Double-Loop-Anordnung ergeben sich Nullfelder N1 und N2, die sich jedoch innerhalb des äusseren Ballons 9 befinden und sich somit nicht negativ auf die Bildgebung auswirken, da sie auf Grund der Wirkung des als Distanzhalter wirkenden Ballons 9 nicht an der zu untersuchenden Gefässwand anliegen. Hieraus resultiert eine relativ konzentrische Feldverteilung, die selbst das Fernfeld noch verhältnismässig stark ausleuchtet.

In Fig. 5 ist ein Diagramm zur Verdeutlichung der Schwankungen des Magnetfeldbetrages für eine Double-Loop-Spulenanordnung gemäss Fig. 3 dargestellt. Zur Erläuterung dieses Diagramms ist rechts stehend nochmals die konzentrische Anordnung des Trägerteils 2 und des Distanzhalters 9 mit den aufgebrachten Leitern 5 bis 8 und den zugeordneten Strömen I1, I2 und I3 sowie I4 dargestellt.

Vorteilhafter Weise ist mit dieser Konfiguration eine Reduktion der Schwankung des Magnetfeldbetrages direkt an der Gefäßwand um ± 13 % möglich. Im Vergleich hierzu würde die Schwankung des Magnetfeldbetrages der Eingangs erläuterten Anordnung einer Single-Loop-Spule, falls sie sich ebenfalls auf dem Trägerteil 2 befinden und vom Abstandhalter 9 umgeben werden würden, ± 36 % betragen.

In Fig. 6 ist als alternative Ausführungsform eine Dreifach-Anordnung dargestellt, bei der auf dem Trägerteil 2 drei Leiter 5, 7, 12 sowie 6, 8, 13 angeordnet sind, deren zugeordnete jeweils gleichgerichtete Ströme, in dem rechts stehenden Kasten der Fig. 6 dargestellt sind.

Die sich ergebende Schwankung des Magnetfeldbetrages ist aus dem Diagramm gemäss Fig. 6 ersichtlich. Aus dieser Darstellung ergibt sich, dass sich die Schwankung des Magnetfeldbetrages bei einer Triple-Loop-Anordnung, also mit drei Windungen, weiter auf ± 6 % minimieren lässt. Je höher die Anzahl der verwendeten Windungen, desto geringer werden die Magnetfeldschwankungen direkt an der Gefäßwand bei ansonsten gleichbleibenden Abmessungen von Träger 2 und Distanzhalter 9. Hält man dagegen die Schwankungen des Magnetfeldbetrages direkt an der Gefäßwand konstant, bei z. B. ca. ± 15 %, kann bei Verwendung der Triple-Loop-Konfiguration der Durchmesser des Trägers 2 im Verhältnis zum Durchmesser des Distanzhalters 9 vergrößert werden. Hieraus resultiert ein größerer effektiverer Durchmesser der eigentlichen Spulenanordnung, sodass ein stärkeres Magnetfeld im Fernfeld erzeugt wird. Dies äußert sich in einer Steigerung der Signaleindringtiefe.

## Patentansprüche

1. Bildgebungskatheter (1)
- mit einem langgestreckten Trägerteil (2),
- mit einer elektromagnetischen Detektionsspule mit aus zumindestens zwei Windungen (3, 4), die auf dem Trägerteil (2) angeordnet sind und deren benachbart auf dem Trägerteil (2) in dessen Längsrichtung (L) positionierte Leiter (5 bis 8) gleichgerichtet bestromt sind, und
- mit einem Distanzhalter (9), der um das Trägerteil (2) herum angeordnet ist.

2. Bildgebungskatheter nach Anspruch 1, **dadurch gekennzeichnet, dass** das Trägerteil (2) als aufweitbarer Ballon ausgebildet ist.

3. Bildgebungskatheter nach Anspruch 2, **dadurch gekennzeichnet, dass** der Ballon (2) Teil eines handelsüblichen PTA-Katheters ist.

4. Bildgebungskatheter nach einem der Ansprüche 1 bis 3, **dadurch gekennzeichnet, dass** die Detektionsspule als Magnetresonanz-Spule ausgebildet ist.

5. Bildgebungskatheter nach einem der Ansprüche 1 bis 4, **dadurch gekennzeichnet, dass** die Leiter (5 bis 8) der Spulen (3, 4) aus Kupfer mit einem möglichst grossen Durchmesser, insbesondere in einem Bereich von 0,1 bis 0,3 mm, vorzugsweise 0,18 mm, bestehen.

6. Bildgebungskatheter nach einem der Ansprüche 1 bis 5, **dadurch gekennzeichnet, dass** die Leiter (5 bis 8) mittels eines Klebers auf der Aussenfläche (10) des Trägerteils (2) fixiert sind.

7. Bildgebungskatheter nach einem der Ansprüche 1 bis 6, **dadurch gekennzeichnet, dass** die Detektionsspule Dipol-Charakter aufweist.

8. Bildgebungskatheter nach einem der Ansprüche 1 bis 7, **dadurch gekennzeichnet, dass** der Distanzhalter (9) als inflatierbarer Aussenballon ausgebildet ist.

9. Bildgebungskatheter nach Anspruch 8, **dadurch gekennzeichnet, dass** der Aussenballon (9) konzentrisch um das Trägerteil (2) angeordnet ist.

10. Bildgebungskatheter nach einem der Ansprüche 2 bis 9, **gekennzeichnet durch** ein Anschlussstück (11), das separate Zuleitungen für den Ballon (2), den Aussenballon (9), für einen Führungsdraht und ein elektrisches Anschlusskabel, vorzugsweise in Form eines Koaxkabels, aufweist.
